Europäisches Patentamt

(19) European Patent Office

Office européen des brevets

(11) Numéro de publication: **0 012 324**
**B1**

(12) **FASCICULE DE BREVET EUROPEEN**

(45) Date de publication du fascicule du brevet: **17.02.82**

(51) Int. Cl.³: **H 01 L 21/28,**
**H 01 L 21/265**

(21) Numéro de dépôt: **79104877.0**

(22) Date de dépôt: **04.12.79**

(54) Procédé de formation de contacts sur des régions semi-conductrices peu profondes.

(30) Priorité: **06.12.78 US 966924**

(43) Date de publication de la demande:
**25.06.80 Bulletin 80/13**

(45) Mention de la délivrance du brevet:
**17.02.82 Bulletin 82/7**

(84) Etats contractants désignés:
**DE FR GB**

(56) Documents cités:
**DE - B2 - 2 449 542**
**US - A - 4 135 292**

(73) Titulaire: **International Business Machines Corporation**
**Armonk, N.Y. 10504 (US)**

(72) Inventeur: **Crowder, Billy Lee**
**Rd. No. 2**
**Putnam Valley New York 10579 (US)**

(74) Mandataire: **Colas, Alain**
**COMPAGNIE IBM FRANCE Département de Propriété Industrielle**
**F-06610 - La Gaude (FR)**

Courier Press, Leamington Spa, England.

Procédé de formation de contacts sur des régions semi-conductrices peu profondes

**Domaine technique**

La présente invention concerne, de façon générale, les circuits intégrés réalisés dans des substrats semi-conducteurs et, plus particulièrement, la formation de contacts métalliques réalisés sur des régions semiconductrices peu profondes.

**Etat de la technique antérieure**

La diminution des dimensions physiques des dispositifs formés dans des circuits intégrés, afin d'augmenter la vitesse de fonctionnement et la densité de ces derniers, s'est accompagnée d'une diminution des dimensions de la jonction p-n formée entre une région donnée et le substrat semi-conducteur monocristallin ou, en d'autres termes, d'une réduction de la profondeur de cette région.

Lorsqu'un métal est employé pour former un contact avec un matériau semi-conducteur, ce métal tend à pénétrer dans celui-ci d'une façon non uniforme sous la forme de pointes. Ces dernières, si la profondeur de la région située au-dessous du contact est insuffisante, peuvent pénétrer jusqu'à la jonction p-n et, par conséquent, créer un court-circuit. Le résultat de cette pénétration non uniforme est que, lorsqu'un grand nombre de contacts sont établis avec des régions peu profondes, un grand nombre de ceux-ci sont court-circuités, ce qui entraîne une augmentation du pourcentage de dispositifs défectueux lors de la fabrication.

Il s'agit en l'occurrence d'un problème bien connu qui serait dû au fiat que le silicium ne se dissout pas de façon uniforme dans le métal et que ce dernier peut pénétrer le long des défauts de la région semi-conductrice. On a cherché à contrôler cette pénétration et à la rendre uniforme, par exemple en utilisant une barrière de charge d'espace entre la région semi-conductrice et la couche métallique. Cependant, lorsque la profondeur de la région délimitée par la jonction diminue, les techniques employées perdent de leur efficacité et le nombre de courts-circuits, constatés dans les dispositifs à forte intégration, augmente.

**Exposé de l'invention**

La présente invention pallie les inconvénients décrits ci-dessus, par la formation d'une couche amorphe dans la région de contact du matériau semi-conducteur. Le terme "amorphe" peut être ici défini comme signifiant "non cristallin". La couche amorphe présente un volume égal à celui du matériau semi-conducteur nécessaire pour saturer le métal dans la région de contact pendant l'opération de recuit. Cette couche amorphe peut être réalisée en exposant la région de contact choisie à une énergie de rupture des liaisons atomiques, par exemple, au moyen d'une implantation ionique. Lors de la fabrication d'un circuit intégré, un trou de contact est percé dans une couche de passivation constituée, par exemple, par un oxyde, et la couche amorphe est formée dans cette ouverture par implementation ionique. Lorsque celle-ci est effectuée en utilisant des ions d'une impureté déterminant un type de conductivité déterminé, on obtient un meilleur contact ohmique et, d'autre part, une partie de l'oxyde de passivation qui recouvre le cristal reçoit une certaine quantité d'atomes d'impureté qui serviront à un piégeage ultérieur. Le métal est ensuite appliqué généralement par évaporation, puis une opération de recuit permet de former un contact ohmique plan entre le matériau semi-conducteur, tel que le silicium, et le métal tel que l'aluminium, sans formation de pointes.

D'autres objets, caractéristiques et avantages de la présente invention ressortiront mieux de l'exposé qui suit, fait en référence aux dessins annexés à ce texte, qui représentent un mode de réalisation préféré de celle-ci.

**Brève description des figures**

La Figure 1 représente, en coupe, un dispositif de l'art antérieur et, plus particulièrement, les pointes qui se forment dans une région peu profonde, délimitée par une jonction p-n et recouverte d'un contact métallique.

La Figure 2 est une coupe illustrant le procédé de la présente invention et la couche semi-conductrice amorphe.

La Figure 3 est une coupe illustrant le procédé de la présente invention ainsi que la pénétration du métal après l'opération de recuit.

**Mode de réalisation préférée de l'invention**

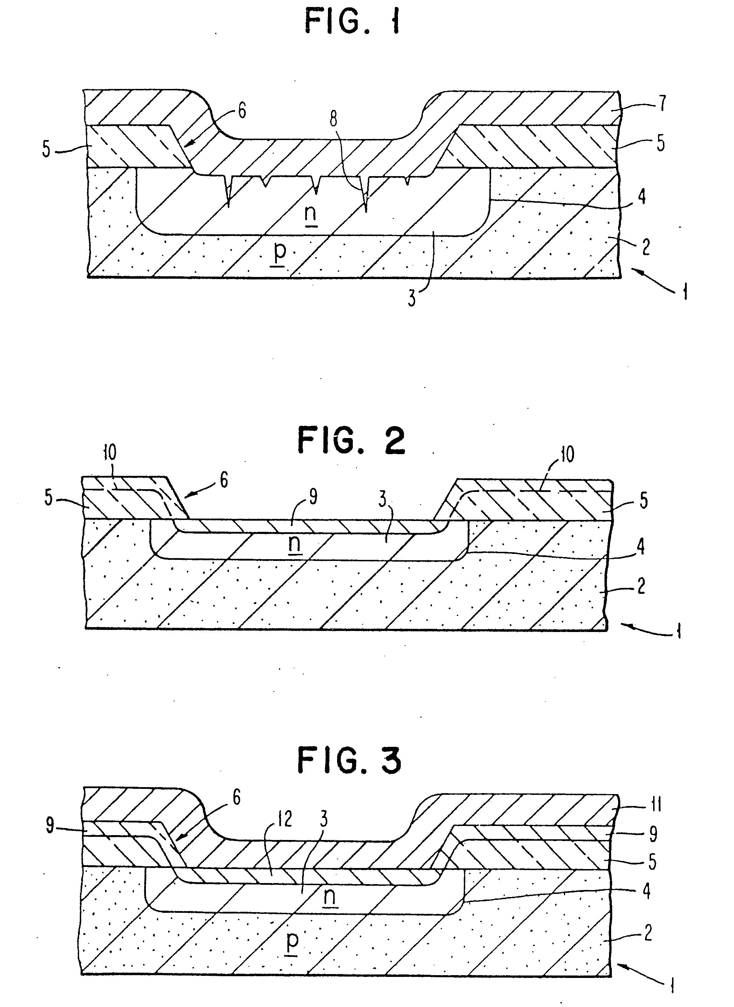

La Figure 1 illustre le problème de formation de pointes qui se pose dans l'art antérieur et son effet sur des régions peu profondes.

Etant donné que, dans la technologie actuelle des semi-conducteurs, on utilise généralement du silicium comme matériau semi-conducteur et de l'aluminium comme métal, la description de l'invention sera faite en relation avec l'emploi de ces deux matériaux, bien que, comme le comprendra aisément l'homme de l'art, les principes de l'invention soient applicables à une vaste gamme de matériaux.

On a représenté sur la Figure 1 un substrat en silicium cristallin contenant une région 2 de type p et une région 3 de type n qui sont séparées par une jonction p-n 4. Le silicium 1 est recouvert d'un oxyde de passivation 5 comportant une ouverture 6 au travers de laquelle un conducteur en aluminium 7 établira un contact avec la région 3.

En pratique, lorsque l'aluminium est soumis à une opération de recuit pour former le contact ohmique, ce métal pénètre de façon inégale à l'intérieur de la région en silicium 3 et forme des pointes 8 dont il n'est pas possible de prévoir le nombre et la longueur, si bien que, lorsque la jonction 4 est suffisamment proche de la surface du substrat cristallin 1, les pointes 8 peuvent effectivement court-circuiter la jonction et, partant, augmenter la quantité de dispositifs défectueux réalisés. Ce problème se pose avec d'autant plus d'acuité que, pour augmenter la vitesse de fonctionnement et la densité des dispositifs, on réduit au maximum la distance séparant la jonction 4 de la surface.

On a représenté, en coupe, sur la Figure 2, une région de contact, sur un dispositif semi-conducteur en silicium, qui illustre le procédé de la présente invention.

Sur la Figure 2, le silicium cristallin 1 comporte une région 2 de type p à l'intérieur de laquelle se trouve une région 3 de type n séparée de la région 2 par une jonction p-n 4. Une couche de passivation 5 en dioxyde de silicium comporte une ouverture 6 permettant d'exposer la surface du silicium 1. Une implantation ionique de faible énergie est effectuée au travers de l'ouverture 6. L'énergie employée et la durée de cette implantation ionique sont telles que la structure cristalline est convertie en une région amorphe 9. Le volume de cette région 9 est égal à celui du matériau qui se dissolvera dans l'aluminium lors d'une étape de recuit consécutive à la formation du contact en aluminium. Il y a évidemment intérêt à maintenir la température de recuit à une valeur inférieure à celle à laquelle la phase amorphe se reforme épitaxialement sur le silicium cristallin, soit une température comprise entre 550° et 600°C. Il est également nécessaire de veiller à ce que la couche amorphe disparaisse pendant ce processus de recuit de manière à éviter la formation d'une résistance de contact élevée qui serait indésirable. L'implantation ionique est une technique particulièrement commode car elle permet d'appliquer une énergie suffisante pour rompre les liaisons cristallines atomiques sans cependant pénétrer plus profondément qu'on ne le désire. Une source d'ions particulièrement souhaitable à cette fin est un dopant déterminant un type de conductivité correspondant à celui de la couche de silicium exposée dans l'ouverture 6; en l'occurrence, du phosphore ou de l'arsenic peut être employé pour une conductivité de type n. En effet, l'un ou l'autre de ces éléments servirait de dopant supplémentaire de type n dans le trou de contact et permettrait d'améliorer le contact ohmique, ce qui aurait pour effet de réduire toute barrière de potentiel telle qu'une barrière de Schottky. Par ailleurs, un tel dopant permettrait de doper l'oxyde de passivation 5 de la façon indiquée par la ligne pointillée 10, constituant ainsi une technique de piégeage classique du type utilisé avec les verres au phosphosilicate.

La mince région amorphe, créée dans l'ouverture 6, constitue une source de silicium qui pourra aisément se dissoudre dans l'aluminium lors de l'étape de recuit consécutive à la formation du contact et est ainsi appelée région de "commande de dissolution". Une telle dissolution uniforme du silicium permet en effet d'éviter la formation des pointes représentées en 8 sur la Figure 1.

On a représenté sur la Figure 3 le contact en aluminium réalisé conformément à la présente invention. Comme le montre cette figure, un cristal 1 comporte une région 2 de type p et une région 3 de type n séparées par une jonction p-n 4. Une couche de passivation 5 en dioxyde de silicium comporte une ouverture 6 permettant d'exposer une partie de la région 3. Une couche d'aluminium 11 est appliquée sur la couche 5 et sur la couche amorphe 9 de la Figure 2. Une étape ultérieure de recuit porte la température à une valeur à laquelle la région amorphe 9 de la Figure 2 est dissoute dans l'aluminium 11, formant lors de sa solidification une légère avancée 12 dans la région 3 de type n. Cette avancée 12 est parallèle à la jonction 4.

Compte tenu des faibles dimensions physiques utilisées et des énergies requises, les précisions données ci-après à titre indicatif, pourront faciliter la mise en oeuvre de la présente invention par l'homme de l'art. La superficie du dispositif peut être égale ou inférieure à 5 × 5 microns. La région amorphe est formée en implantant du phosphore selon une concentration de $3 \times 10^{15}/cm^2$ à un niveau d'énergie de 25 KeV. La région 12 a une épaisseur d'environ 500 Å et contient environ $10^{21}$ atomes de phosphore par $cm^3$.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Procédé de formation de contacts métalliques sur des cristaux semi-conducteurs du genre dans lequel un métal est déposé sur un matériau semi-conducteur, caractérisé en ce qu'il comprend:

une étape de transformation dudit matériau semi-conducteur, situé dans la région de contact, en un matériau amorphe, cette transformation s'effectuant pour un volume de matériau égal au volume nécessaire pour saturer le métal au cours d'une étape de recuit consécutive au dépôt dudit métal.

2. Procédé de dépôt d'un contact métallique sur une région d'un cristal semi-conducteur selon la revendication 1, caractérisé en ce que l'on applique le métal sur cette région après sa transformation en région amorphe, et que l'on effectue l'opération de recuit du métal et du matériau semi-conducteur.

3. Procédé de formation de contacts métalliques selon les revendications 1 et 2 caractérisé en ce que le métal est de l'aluminium et le cristal semi-conducteur est constitué par une région de silicium de faible profondeur, et en ce que:

l'aluminium est déposé par évaporation sur le silicium après sa transformation en région amorphe,

l'étape de recuit, réalisée après le dépôt de l'aluminium, est effectuée à une température permettant de dissoudre la région amorphe.

4. Procédé de formation d'un contact ohmique sur une région cristalline semiconductrice de faible profondeur, incluse dans un substrat semi-conducteur, selon la revendication 2, le substrat et la région étant recouverts d'une couche de passivation, caractérisé en ce que la région amorphe est formée par bombardement ionique d'une impureté d'un type de conductivité déterminé, ce bombardement s'effectuant après formation d'une ouverture dans la couche de passivation, cette dernière étant également dopée par ledit bombardement.

5. Procédé selon la revendication 4, caractérisé en ce que ledit substrat semi-conducteur et la région cristalline sont en silicium, et que ledit métal est de l'aluminium.

6. Procédé selon l'une quelconque des revendications précédentes, caractérisé en ce que la température de l'opération de recuit est inférieure à la température à laquelle le matériau amorphe se reforme épitaxialement sur le semi-conducteur cristallin.

**Claims**

1. A method for forming metal contacts on semiconductior crystals, wherein a metal is deposited on a semiconductor material, characterized in that it comprises: a step of transforming said semiconductor material located in the contact region into an amorphous material, whereby this transformation covers a material volume which is equal to the volume required to saturate the metal during an annealing step following the deposition of said metal.

2. A method for depositing a metal contact on a region on a semiconductor crystal according to claim 1, characterized in that the metal is disposed on this region after it has been transformed into an amorphous region and then the metal and the semiconductor material are submitted to an annealing process.

3. A method for forming metal contacts according to any one of claims 1 and 2, characterized in that the metal consists of aluminium and the semiconductor crystal is made of a shallow silicon region, and in that: the aluminium is vapour-deposited on the silicon after it has been transformed into an amorphous region, the annealing step performed after the aluminium deposition takes place at a temperature permitting the amorphous region to be dissolved.

4. A method for forming an ohmic contact on a shallow, crystalline semiconductor region contained in a semiconductor substrate according to claim 2, wherein the substrate and the region are covered by a passivation layer, characterized in that the amorphous region is formed by ion bombardment of an impurity of a given type of conductivity, the bombardment taking place after forming a window in the passivation layer which is also doped by said bombardment.

5. A method according to claim 4, characterized in that said semiconductor substrate and the crystalline region are of silicon and said metal consists of aluminium.

6. A method according to any one of the preceding claims, characterized in that the temperature of the annealing process is below the temperature at which the amorphous material is epitaxially retransformed on the crystalline semiconductor.

**Patentansprüche**

1. Verfahren zum Herstellen von Metallkontakten auf Halbleiterkristallen, bei dem ein Metall auf einem Halbleitermaterial abgeschieden wird, dadurch gekennzeichnet, daß es folgendes einschließt:

einen Verfahrensschritt zum Umwandeln des sich über dem Kontaktbereich befindlichen Halbleitermaterials in ein amorphes Material, wobei die Umwandlung ein Materialvolumen umfaßt, das dem Volumen gleichkommt, das zum Sättigen des Metalls im Laufe des dem Abscheiden des Metalls folgenden Ausglühen erforderlich ist.

2. Verfahren zum Abscheiden eines Metallkontaktes auf einem Bereich eines Halbleiterkristalls nach Anspruch 1, dadurch gekennzeichnet, daß das Metall auf diesem Bereich abgeschieden wird nachdem er in einen amorphen Bereich verwandelt wurde, und daß danach das Ausglühen des Metalls und des Halbleitermaterials vorgenommen wird.

3. Verfahren zum Herstellen von Metallkontakten nach den Ansprüchen 1 und 2, dadurch gekennzeichnet, daß das Metall aus Aluminium besteht und der Halbleiterkristall durch einen Bereich geringer Tiefe gebildet wird, dadurch gekennzeichnet, daß

das Aluminium durch Verdampfen auf das Silicium aufgebracht wird, nachdem dieses in einen amorphen Bereich verwandelt worden ist,

der Ausglühprozeß nach dem Aufbringen des Aluminiums bei einer Temperatur stattfindet, die das Auflösen des amorphen Bereichs erlaubt.

4. Verfahren zum Herstellen eines ohmschen Kontaktes auf einem kristallinen Halbleiterbereich geringer Tiefe, der in einem Halbleitersubstrat eingeschlossen ist, nach Anspruch 2, wobei das Substrat und der Bereich mit einer Passivierungsschicht überzogen sind, dadurch gekennzeichnet, daß der amorphe Bereich durch Ionenbeschuß mit einem Fremdstoff eines vorbestimmten Leitfähigkeitstyps hergestellt wird, wobei der Beschuß nach dem Herstellen einer Öffnung in der Passivierungsschicht stattfindet und letztere ebenfalls durch den Beschuß dotiert wird.

5. Verfahren nach Anspruch 4, dadurch gekennzeichnet, daß das Halbleitersubstrat und der kristalline Bereich aus Silicium bestehen und das Metall aus Aluminium ist.

6. Verfahren nach einem der vorhergehenden Ansprüche, dadurch gekennzeichnet, daß die Temperatur des Ausglühprozesses unter der Temperatur liegt, bei der das amorphe Material sich auf dem kristallinen Halbleiter epitaktisch umwandelt.

# FIG. 1

# FIG. 2

# FIG. 3